(19) Europäisches Patentamt / European Patent Office / Office européen des brevets

(11) **EP 1 976 112 A1**

(12) **DEMANDE DE BREVET EUROPEEN**

(43) Date de publication:
**01.10.2008 Bulletin 2008/40**

(51) Int Cl.:
*H03F 3/45* $^{(2006.01)}$

(21) Numéro de dépôt: **08290259.4**

(22) Date de dépôt: **19.03.2008**

(84) Etats contractants désignés:
**AT BE BG CH CY CZ DE DK EE ES FI FR GB GR HR HU IE IS IT LI LT LU LV MC MT NL NO PL PT RO SE SI SK TR**
Etats d'extension désignés:
**AL BA MK RS**

(30) Priorité: **27.03.2007  FR 0754069**

(71) Demandeur: **Commissariat à l'Energie Atomique 75015 Paris (FR)**

(72) Inventeur: **Freitas, Philippe 38000 Grenoble (FR)**

(74) Mandataire: **Bonnans, Arnaud Santarelli, 14 avenue de la Grande Armée, BP 237 75822 Paris Cedex 17 (FR)**

(54) **Circuit électronique amplificateur comprenant une paire différentielle et un système de contre-réaction**

(57)  Un circuit électronique amplificateur avec au moins un étage d'amplification, comprenant une paire différentielle comprenant deux transistors d'entrée commandés respectivement par deux signaux d'entrée et des moyens de mesure (R1, R2) de la tension de mode commun de sortie (vcom) de l'amplificateur, comprend au moins un premier (3a) et deuxième (3b) éléments électronique, chaque élément électronique (3a, 3b) comprenant une première grille (g1a, g1b) et seconde grille (g2a, g2b), une source (s3a, s3b) et un drain (d3a, d3b), les premières grilles (g1a, g1b) des premier et deuxième éléments électroniques (3a, 3b) étant connectées entre elles et au drain (d3a) du premier élément électronique (3a), l'une des secondes grilles (g2a, g2b) des éléments électroniques (3a, 3b) recevant la tension de mode commun de sortie mesurée (vcom), l'autre des secondes grilles recevant une tension de référence (vctrl).

Utilisation dans toute application utilisant des paires différentielles, par exemple un amplificateur, un oscillateur ou des filtres actifs.

Fig. 1

EP 1 976 112 A1

**Description**

La présente invention concerne un circuit électronique amplificateur comprenant une paire différentielle.

De manière générale, elle concerne un circuit électronique comprenant une paire différentielle et un système de contre-réaction contrôlant la tension de mode commun de sortie de l'amplificateur.

Plus particulièrement, elle concerne la conception d'un circuit électronique amplificateur comprenant une paire différentielle en entrée recevant deux signaux d'entrée différentiels et fournissant en sortie deux signaux de sortie différentiels et comprenant un système de contre-réaction contrôlant la tension de mode commun de sortie.

Il est connu qu'une paire différentielle est formée de deux transistors identiques et polarisés par une même source de courant ou des sources de courant distinctes.

La paire différentielle est par exemple la partie active d'un amplificateur différentiel.

L'objet de la paire différentielle est l'amplification de la différence entre deux signaux d'entrée de la paire différentielle.

Les tensions de sortie de l'amplificateur sont ainsi composées en pratique d'une partie de tension de mode différentiel et d'une partie de tension de mode commun.

La tension de mode différentiel de sortie correspond à la différence des signaux d'entrée amplifiée par le gain différentiel et la tension de mode commun de sortie correspond à la somme divisée par deux des signaux de sortie ou autrement dit à la moyenne des signaux de sortie.

Afin d'éviter des problèmes de saturation en sortie et de garder une amplification la plus linéaire possible, il est préférable que la tension de mode commun reste proche d'une valeur prédéfinie.

Un paramètre représentatif de la qualité d'un amplificateur différentiel est le taux de rejection du mode commun, connu sous le nom de TRMC (CMRR en anglais pour « Commun Mode Rejection Ratio »), et correspond au rapport entre le gain en mode différentiel et le gain en mode commun. Le paramètre TRMC est maximisé lorsque le gain en mode commun est minimisé.

De plus, la tension de mode commun de sortie subit des variations dépendantes des variations d'autres paramètres du circuit.

Toute variation des dimensions des transistors de la paire différentielle lors de sa fabrication peut provoquer un déséquilibre entre les branches de l'amplificateur différentiel, entrainant des variations de la tension de mode commun de sortie.

D'autres facteurs extérieurs, comme par exemple la température, peuvent affecter différemment les transistors de la paire différentielle et le reste du circuit amplificateur, entrainant des variations de la tension de mode commun de sortie.

La présence de variations de la tension de mode commun de sortie perturbe les performances de l'amplificateur différentiel, en particulier le gain en mode différentiel et l'excursion des signaux de sortie.

Il est ainsi nécessaire non seulement de contrôler la valeur de la tension de mode commun de sortie mais aussi de diminuer la dépendance de la valeur de cette tension du fait des variations d'autres paramètres du circuit.

Il a, de ce fait, été proposé des techniques visant à contrôler la valeur de la tension en mode commun de sortie des amplificateurs.

Une technique connue consiste en l'extraction de la tension de mode commun de sortie, pour ensuite réaliser une comparaison entre cette tension extraite et une tension de référence, et enfin amplifier le signal résultant de cette comparaison. Ce signal d'erreur amplifié est ensuite réinjecté dans la paire différentielle à travers ses éléments de polarisation.

Cette technique permet un bon contrôle de la tension de mode commun, mais sa mise en oeuvre implique une consommation de surface de silicium et l'augmentation de la consommation de courant, dues à l'ajout des composants supplémentaires dédiés à l'extraction de la tension de mode commun, à la comparaison de cette tension avec une tension de référence et à l'amplification du signal d'erreur.

Une deuxième technique consiste à extraire une information sur la tension de mode commun d'entrée et à l'injecter de manière appropriée dans le circuit afin de compenser l'impact de ses variations sur la tension de mode commun de sortie.

Cette technique nécessite également l'ajout de composants. En outre, sa consommation de courant est élevée alors qu'elle n'a pas la précision de la première technique. Il s'agit juste en effet d'une compensation de l'impact des variations du signal d'entrée sur la tension en mode commun de sortie et non d'un contrôle de la tension en mode commun de sortie.

Le document IEEE « A 0.5V Bulk-Input fully differential operational transconductance amplifier » (Shouri Chatterjee, Yannis Tsividis and Peter Kinget. Department of electrical engineering, Columbia University, New York, USA) décrit une technique de réinjection de la tension de mode commun de sortie sur les éléments de polarisation. Cette technique est aussi moins précise que la première technique, la tension de mode commun de sortie n'étant pas comparée à une tension de référence.

La présente invention a pour but de résoudre certains au moins des inconvénients précités et de proposer un circuit électronique comprenant un système précis de contrôle de la tension de mode commun de sortie d'un amplificateur comprenant une paire complètement différentielle en entrée, sans perte élevée de surface et sans augmentation de la consommation de courant.

A cet effet, l'invention concerne un circuit électronique amplificateur avec au moins un étage d'amplification, le premier étage d'amplification comprenant une paire différentielle comprenant deux transistors d'entrée commandés respectivement par deux signaux d'entrée ; des moyens de mesure de la tension de mode commun de sortie de l'amplificateur; et au moins un premier et deuxième éléments électronique, chaque élément électronique comprenant une première grille et une seconde grille, une source et un drain, les premières grilles des premier et deuxième éléments électroniques étant connectées entre elles et au drain du premier élément électronique et formant ainsi une configuration de miroir de courant, l'une des secondes grilles des premier et deuxième éléments électroniques recevant la tension de mode commun de sortie mesurée, l'autre des secondes grilles recevant une tension de référence, le premier élément électronique étant traversé par un courant de référence, le second élément électronique étant adapté à polariser tout ou partie d'au moins un des étages d'amplification.

On profite ainsi des caractéristiques du montage en « pseudo » miroir de courant pour réaliser une contre-réaction de mode commun de conception relativement compacte. La tension en mode commun de sortie de l'amplificateur est ainsi contrôlée (aussi bien en valeur qu'en variations) et adaptée à la tension de référence, grâce à l'auto-équilibrage en courant du miroir de courant.

Selon un mode de réalisation, le second élément électronique est relié à la source commune des transistors de la paire différentielle.

Selon un autre mode de réalisation, l'amplificateur comprend un troisième élément électronique, les première et seconde grilles du troisième élément électronique étant respectivement reliées aux première et seconde grilles du deuxième élément électronique, les deuxième et troisième éléments électroniques étant chacun reliés à un des transistors de la paire différentielle.

Les composants électroniques ajoutés à la paire différentielle ne sont pas nombreux et en conséquence la surface de silicium nécessaire est réduite, comme il sera expliqué plus loin dans ce document.

Par exemple, dans le circuit électronique amplificateur, la tension de mode commun de sortie mesurée est appliquée à la seconde grille du second élément électronique et la tension de référence est appliquée à la seconde grille du premier élément électronique.

La tension de mode commun de sortie est par exemple extraite sur les bornes des transistors de la paire différentielle.

Selon une variante de réalisation, le nombre d'étages d'amplification de la différence des deux signaux d'entrée appliqués aux transistors de la paire différentielle est impair et la tension de mode commun de sortie est extraite au niveau du dernier étage d'amplification.

En variante, dans le circuit électronique amplificateur la tension de mode commun de sortie est appliquée à la seconde grille du premier élément électronique et la tension de référence est appliquée à la seconde grille du second élément électronique.

La paire différentielle appartient à un premier étage d'amplification de la différence des deux signaux d'entrée appliqués aux transistors de la paire différentielle et le circuit électronique amplificateur comprend un second étage d'amplification de cette différence, la tension de mode commun de sortie mesurée étant extraite sur les bornes des transistors du second étage d'amplification.

Selon une variante, le nombre d'étages d'amplification de la différence des deux signaux d'entrée appliqués aux transistors de la paire différentielle est pair, et la tension de mode commun de sortie est extraite au niveau du dernier étage d'amplification.

Selon une possibilité de mise en oeuvre, un des éléments électroniques comprend deux transistors simple-grille montés en parallèle.

Ainsi, ces transistors ont leur source et leur drain « communs », c'est-à-dire que les sources des transistors constitutifs de l'élément électronique sont reliées l'une à l'autre et que les drains de ces mêmes transistors sont reliés l'un à l'autre.

En variante, un élément des éléments électroniques comprend un transistor double-grille présentant deux grilles

Particulièrement, un tel transistor est un transistor double-grille.

Les transistors à grilles multiples (connus sous le nom de transistors multi-grilles) présentent de meilleures caractéristiques que les transistors conventionnels à grille unique, réduisant l'effet connu dit de « canal court », dû à la réduction des dimensions de composants, à laquelle on tend avec l'évolution de la technologie.

Ce type de transistor présente en outre un gain de surface additionnel.

Avantageusement, un élément des éléments électroniques comprend un transistor double-grille de type FinFet ou planaire. Ce type de transistor est donc particulièrement adapté ici.

Selon un mode de réalisation, les moyens de mesure de la tension de mode commun de sortie de la paire différentielle comprennent deux résistances, placées en série entre deux sorties de l'amplificateur délivrant les signaux de sortie.

En variante, les moyens de mesure de la tension de mode commun de sortie de la paire différentielle comprennent des condensateurs et des interrupteurs.

D'autres particularités et avantages de l'invention apparaîtront encore dans la description ci-après, faite en référence aux dessins annexés, donnés à titre d'exemples non limitatifs, dans lesquels:

- la figure 1 est un schéma électrique d'un amplificateur complètement différentiel avec contre-réaction du mode commun selon un premier mode de réalisation de l'invention;
- la figure 2 est un schéma électrique d'un amplificateur complètement différentiel avec contre-réaction du mode commun selon un second mode de réalisation de l'invention ;
- la figure 3 est un schéma électrique d'un amplificateur complètement différentiel avec contre-réaction du mode commun selon un troisième mode de réalisation de l'invention ;
- la figure 4 est un schéma électrique d'un amplificateur complètement différentiel avec contre-réaction du mode commun selon un quatrième mode de réalisation de l'invention ;
- la figure 5 est un schéma électrique d'un amplificateur complètement différentiel avec contre-réaction du mode commun selon un cinquième mode de réalisation de l'invention ;
- la figure 6 est un schéma électrique d'un mode de réalisation du circuit d'extraction de l'amplificateur représenté en figure 5 ;
- la figure 7 est un exemple de chronogramme des signaux de commande pouvant être appliqués au circuit d'extraction représenté en figure 6 ; et
- la figure 8 est un schéma électrique d'un amplificateur complètement différentiel avec contre-réaction du mode commun selon un sixième mode de réalisation de l'invention ;

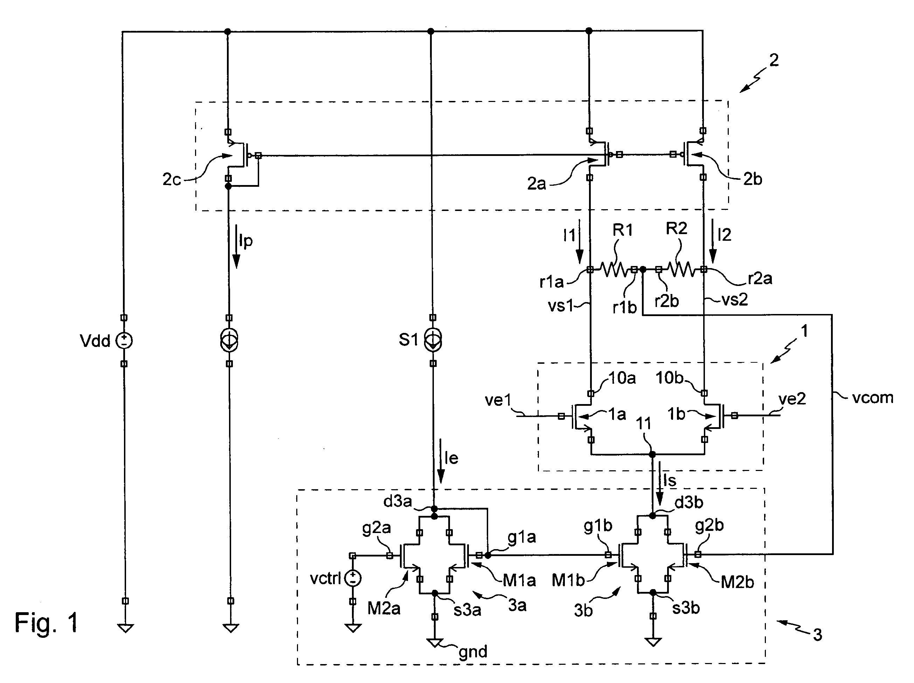

On va décrire en référence à la figure 1 un premier mode de réalisation d'un amplificateur conforme à l'invention comprenant une paire différentielle 1 avec contre-réaction de mode commun.de sortie.

La paire différentielle 1 comprend deux transistors 1 a, 1 b couplés par leur source. Ici, ces deux transistors 1 a, 1 b sont des transistors de type MOS (de l'anglais « Métal Oxyde Semiconductor ») à canal N.

Les signaux de tension d'entrée ve1, ve2 sont appliqués aux grilles des transistors 1 a, 1b de la paire différentielle 1. Le premier signal de tension ve1 est appliqué à la grille du premier transistor 1 a de la paire différentielle 1 et le second signal de tension ve2 est appliqué à la grille du second transistor 1b de la paire différentielle 1.

Le premier signal de sortie vs1 de l'amplificateur est la tension sur le drain 10a du premier transistor 1 a de la paire différentielle 1 et le second signal de sortie vs2 de l'amplificateur est la tension sur le drain 10b du second transistor 1b de la paire différentielle 1.

La polarisation de la paire différentielle 1 est réalisée par leur source commune 11 (polarisation de pied 3) et par chacun des drains 10a, 10b de la paire différentielle 1 (polarisation de tête 2).

La polarisation de tête 2 est un miroir de courant fournissant deux copies I1, I2 d'un courant d'entrée Ip. Ce miroir de courant 2 comprend ainsi trois transistors 2a, 2b, 2c de type MOS à canal P et de dimensions identiques dans cet exemple. Les sources des transistors 2a, 2b, 2c sont connectées à une tension d'alimentation Vdd, positive dans cet exemple. Le premier transistor 2c, monté en diode, est traversé par le courant d'entrée Ip. Le deuxième transistor 2a, et le troisième transistor 2b polarisent la paire différentielle 1 par les drains 10a, 10b des transistors 1 a, 1 b. Les courants I1, I2 qui traversent les deuxième et troisième transistors 2a, 2b sont une copie du (c'est-à-dire identique au) courant d'entrée Ip traversant le transistor premier 2c.

Dans ce mode de réalisation, la polarisation de pied 3 de la paire différentielle 1 est réalisée par deux éléments électroniques 3a, 3b. Chaque élément électronique 3a, 3b est constitué de deux transistors en parallèle, de type MOS à canal N dans cet exemple.

Le premier élément 3a comprend deux transistors M1a, M2a montés en parallèle. Leurs sources communes s3a sont connectées à la masse gnd. Leurs drains communs d3a sont reliés à la grille g1a du premier transistor M1a. Une tension de référence vctrl est appliquée sur la grille g2a du deuxième transistor M2a. Les deux transistors M1a et M2a sont reliés par leurs drains à une source de courant S1 délivrant un courant de référence le.

Le deuxième élément 3b comprend également deux transistors M1b, M2b connectés en parallèle. Leurs sources s3b communes sont également connectées à la masse gnd. Leurs drains d3b communs sont connectés à la source 11 commune de la paire différentielle 1. La grille g2b du second transistor M2b reçoit la tension de mode commun de sortie vcom de l'amplificateur. Le courant total provenant des transistors de la paire différentielle 1 a, 1b et se répartissant dans les transistors M1 b, M2b du second élément est appelé ci-après courant Is.

Le premier transistor M1a du premier élément 3a et le premier transistor M1b du second élément 3b sont connectés en configuration de miroir de courant. C'est-à-dire, la grille g1a du premier transistor M1a du premier élément 3a est connectée à la grille g1b du premier transistor M1b du second élément 3b et aux drains d3a communs des deux transistors M1a, M2a du premier élément 3a.

Ainsi, le courant circulant à travers le premier transistor M1b du second élément 3b est une recopie du courant circulant à travers le premier transistor M1a du premier élément 3a.

Généralement, la polarisation de pied 3 de la paire différentielle 1 est réalisée par une source de courant délivrant un courant fixe prédéfini. Au contraire, dans ce mode de réalisation de la présente invention, le courant traversant le second élément électronique 3b de la polarisation de pied est variable afin de régler la tension de mode commun de sortie comme cela apparaîtra ci-après.

Selon un mode de réalisation de l'invention, l'extraction de la tension de mode commun de sortie vcom est réalisée au moyen de deux résistances R1, R2. Chacune des résistances R1, R2 est connectée par une première extrémité r1 a, r2a, à chacune des sorties de l'amplificateur, c'est-à-dire à chacun des drains 10a, 10b des transistors 1a, 1b de la paire différentielle 1 dans cet exemple. Enfin ces résistances R1, R2 sont connectées entre elles par leurs deuxièmes extrémités r1 b, r2b.

Les deux résistances R1, R2 sont de valeur identique.

Ainsi, la tension de mode commun de sortie vcom est mesurée à l'extrémité commune r1b, r2b des deux résistances R1, R2.

Dans ce mode de réalisation, la contre-réaction du mode commun de sortie est réalisée via la polarisation de pied 3 de la paire différentielle 1. La contra-réaction est réalisée au niveau du second élément 3b de la polarisation de pied 3 et plus précisément de sa grille g2b.

La tension de référence vctrl appliquée au transistor M2a est obtenue par exemple par un circuit générateur de tension de référence. Par exemple, un tel générateur peut comprendre simplement un transistor de type MOS monté en diode et une résistance en série entre la masse et la tension d'alimentation Vdd.

On va décrire à présent le fonctionnement de ces deux éléments 3a, 3b connectés en « pseudo » miroir de courant, c'est-à-dire, connectés en partie en configuration de miroir de courant, comme il a été expliqué ci-dessus.

Lorsque la tension de mode commun de sortie vcom est égale à la tension de référence vctrl, le courant de référence le et le courant Is provenant des transistors 1 a, 1 b de la paire différentielle 1 sont identiques.

Lorsque la tension de mode commun de sortie vcom est supérieure à la tension de référence, le « pseudo » miroir de courant tend à revenir à l'équilibre de sorte que la tension de mode commun de sortie vcom diminue jusqu'atteindre et égaliser la tension de référence vctrl.

En effet, si la tension sur la grille g2b du second transistor M2b augmente, le courant traversant ce transistor M2b est alors supérieur au courant traversant le second transistor M2a du premier élément 3a, les courants traversant le premier transistor M1a du premier élément 3a et le premier transistor M1 b du second élément 3b restant égaux par construction. Le courant Is provenant des transistors 1 a, 1b de la paire différentielle 1 augmente et devient supérieur au courant de référence le. L'appel de courant par la polarisation de pied 3 tend à faire baisser simultanément les tensions de sortie vs1, vs2. Par conséquent la tension de mode commun de sortie vcom diminue. La tension de grille du second transistor M2b du second élément 3b diminuant, le courant traversant ce dernier diminue progressivement jusqu'à une valeur sensiblement égale à celle du courant traversant le second transistor M2a du premier élément 3a. Le courant provenant des transistors 1 a, 1 b de la paire différentielle 1 Is diminue et redevient sensiblement égal au courant de référence le.

De même, lorsque la tension de mode commun de sortie vcom est inferieure à la tension de référence, le « pseudo » miroir de courant agit de sorte que la tension de mode commun de sortie vcom soit augmentée et égalisée à la tension de référence vctrl.

Ainsi, la tension de mode commun de sortie vcom est régulée à une valeur égale à la tension de référence vctrl et n'est pas soumise aux variations de la tension de mode commun d'entrée.

On reconnaît au schéma de la figure 1, un miroir de courant classique formé par deux transistors, le premier transistor M1a du premier élément 3a et le premier transistor M1b du deuxième élément 3b. Ici, les transistors M 1 a, M1 b sont identiques, afin de reproduire un courant identique.

Les dimensions du second transistor M2a du premier élément 3a et du second transistor M2b du second élément 3b sont calculées de sorte à trouver un bon compromis entre le fonctionnement optimal du système de contre-réaction de la tension de mode commun de sortie vcom et l'optimisation de la surface.

Ainsi les dimensions de ces deux transistors M2a, M2b sont, de préférence, supérieures à celles des premiers transistors M1a, M1b de chaque élément pour les raisons suivantes.

Lorsque la tension de référence vctrl est de plus en plus élevée, la tension à la grille g1a du premier transistor M1a du premier élément 3a est de moins en moins élevée jusqu'à ce qu'elle arrive à une tension proche de zéro. Le miroir de courant formé par les transistors M1a, M1b n'est alors plus fonctionnel. Lorsqu'on arrive à cette situation, la tension de référence vctrl et la tension de mode commun de sortie vcom ne sont plus interactives entre elles, c'est-à-dire, la boucle de contre-réaction cesse de fonctionner.

Ainsi, il est nécessaire de retarder le moment où la grille g1a du premier transistor M1a arrive à cette tension de décrochement, c'est-a-dire de diminuer l'impact de la tension de référence vctrl sur la tension à la grille g1a du premier transistor. A cet effet, on peut par exemple augmenter la longueur de grille des seconds transistors M2a, M2b, c'est à dire la distance source-drain sous la grille des ces transistors M2a, M2b.

Néanmoins, les dimensions de ces transistors M2a, M2b doivent rester identiques, afin de maintenir la symétrie du « pseudo » miroir de courant.

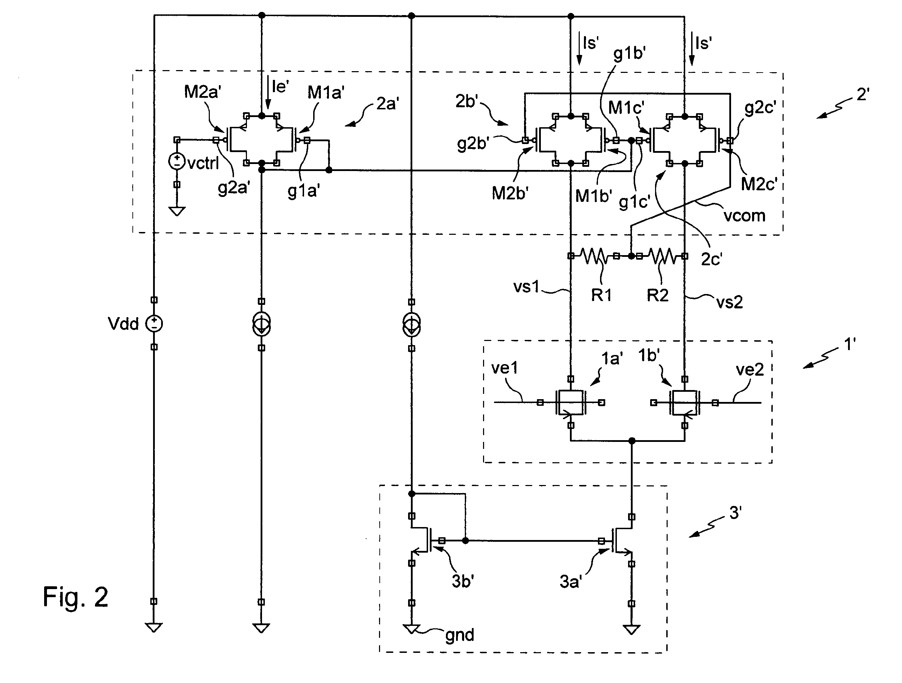

On va décrire à présent en référence à la figure 2 un second mode de réalisation d'un amplificateur comprenant une paire différentielle 1' avec contre-réaction du mode commun de sortie conforme à l'invention.

La paire différentielle 1' est dans cet exemple constituée de deux transistors double-grille 1 a', 1 b', de type MOS à canal N. Les transistors 1 a', 1 b' reçoivent sur leurs grilles des première et seconde tensions d'entrée ve1, ve2. Les tensions présentes sur les drains des transistors 1a', 1b' correspondent respectivement aux première vs1 et seconde vs2 tensions de sortie de l'amplificateur.

Dans ce mode de réalisation, la polarisation de pied 3' est une polarisation classique d'une paire différentielle 1' comprenant deux transistors simple-grille 3a', 3b' de type MOS à canal N. Les sources des transistors 3a', 3b' sont reliées à la masse. Le premier transistor 3b' est monté en diode et reçoit un courant de polarisation. Les grilles des transistors 3a', 3b' sont reliées l'une à l'autre. Par ailleurs, le drain du second transistor 3a' est relié aux sources des transistors de la paire différentielle 1 a', 1 b' afin de polariser la paire différentielle 1'.

L'extraction de la tension de mode commun de sortie vcom est réalisée au moyen de deux résistances R1, R2 placées en série entre les drains des transistors 1a', 1b'.

La contre-réaction du mode commun de sortie est réalisée via la polarisation de tête 2' de la paire différentielle 1'. La contre-réaction est réalisée par trois éléments 2a', 2b', 2c' connectés en configuration de « pseudo » miroir de courant. Une telle configuration fournit deux courants Is' qui sont identiques à un courant de référence Ie' quand la tension de mode commun de sortie vcom est égale à une tension de référence vctrl.

Chaque élément électronique 2a', 2b', 2c' est dans cet exemple constitué de deux transistors simple grille reliés par leurs drains et par leurs sources. Les transistors sont de type MOS à canal P. Les sources des transistors sont reliées à une tension d'alimentation Vdd. Plus précisément, le premier élément 2a' est constitué de deux transistors M1a', M2a', le deuxième élément 2b' de deux transistors M1b', M2b' et le troisième élément 2c' de deux transistors M1c', M2c'. Le premier transistor M1a' du premier élément 2a' est monté en diode. Les grilles g1a', g1b', g1c' des premiers transistors M1a', M1b', M1c' sont reliées l'une à l'autre.

Le premier élément 2a' du « pseudo » miroir de courant est connecté à la tension de référence vctrl. Plus précisément, la tension de référence vctrl est appliquée sur la grille g2a' du second transistor M2a' du premier élément 2a'.

Le deuxième élément 2b' et le troisième élément 2c' du « pseudo » miroir de courant reçoivent la tension de mode commun de sortie vcom. La tension de mode commun est ici prélevée entre les deux résistances R1, R2.

Le courant de référence Ie' du « pseudo » miroir de courant circule à travers le premier élément 2a' du miroir de courant. Le « pseudo » miroir de courant fournit deux courants identiques Is', circulant respectivement à travers le deuxième élément 2b' et le troisième élément 2c' du « pseudo » miroir de courant.

Comme pour le premier mode de réalisation décrit, chacun des éléments 2a', 2b', 2c' du « pseudo » miroir du courant est composé par deux transistors connectés en parallèle et le fonctionnement, ainsi que le dimensionnement des transistors est identique.

Dans les deux modes de réalisation, il est possible que tout ou partie des transistors employés pour la conception du circuit électronique d'une paire différentielle avec contre-réaction du mode commun de tension de sortie soit des transistors à grilles multiples et plus précisément des transistors double-grille. On entend par transistor double-grille dans la présente demande un transistor comprenant une unique zone de drain, une unique zone de source et deux grilles polarisables indépendamment l'une de l'autre.

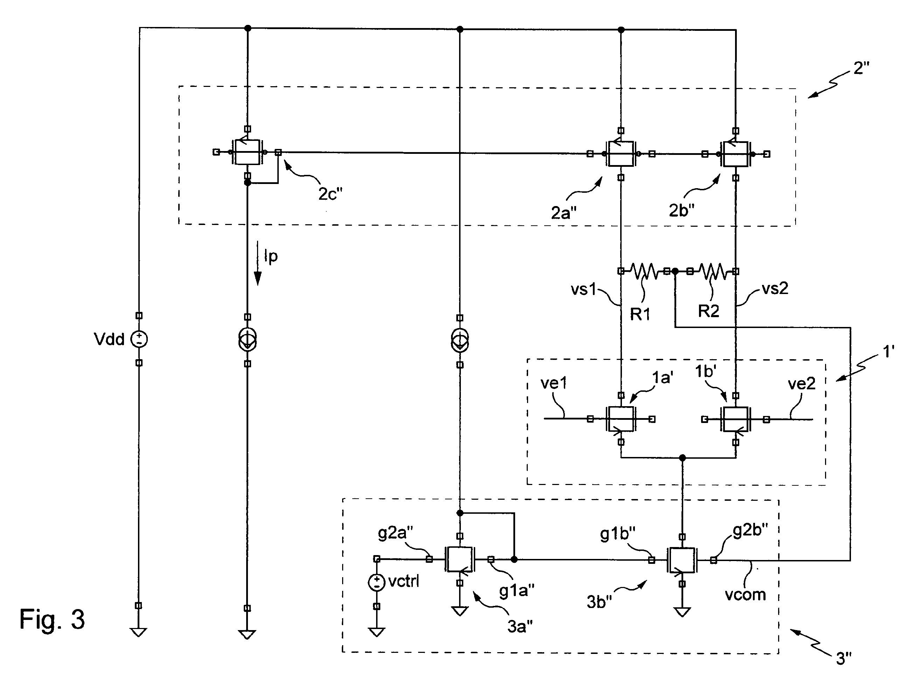

Le circuit électronique amplificateur illustré à la figure 3 comprend une paire différentielle 1' avec contre-réaction du mode commun conçue avec des transistors double-grille, comme celle du circuit représenté en figure 2. Le fonctionnement de ce circuit est similaire à celui décrit en relation avec la figure 1.

La polarisation de tête est similaire à celle du circuit représenté en figure 1 excepté que les transistors simple grille sont remplacés par des transistors double-grille 2a", 2b", 2c" de type MOS à canal P. Les sources des transistors 2a", 2b", 2c" sont reliées à la tension d'alimentation Vdd. Les grilles des transistors 2a", 2b", 2c" sont reliées les une aux autres. Les grilles du premier transistor 2c" sont reliées au drain de ce transistor et à une source de courant délivrant un courant de polarisation Ip. En outre, les drains des deuxième et troisième transistors 2a", 2b" sont reliés respectivement aux drains des transistors 1a', 1 b' de la paire différentielle 1'.

L'extraction de la tension de mode commun de sortie vcom est réalisée au moyen de deux résistances R1, R2 en série entre les drains des transistors 1a', 1 b' de la paire différentielle 1'.

La contre-réaction du mode commun de sortie est réalisée via la polarisation de pied 3" de la paire différentielle 1'. La polarisation de pied 3" est similaire à la polarisation de pied 3 du circuit représenté en figure 1 excepté que chaque élément est ici constitué d'un unique transistor double-grille.

Ainsi, les éléments 3a", 3b" connectés en configuration de « pseudo » miroir de courant comprennent chacun un unique transistor double-grille. Les sources des éléments ou transistors 3a", 3b" sont connectées à la masse. La première grille g1a" du premier transistor 3a" est connectée à la première grille g1b" du deuxième transistor 3b". La première grille g1a" du premier transistor 3a" est reliée au drain de ce transistor. La seconde grille g2a" du premier transistor 3a" reçoit la tension de référence vctrl et la seconde grille g2b" du deuxième transistor 3b" reçoit la tension de mode commun de sortie vcom.

On notera que d'un point de vue électrique, un transistor double-grille a un fonctionnement équivalent à celui de deux transistors en parallèle reliés par leurs sources et par leurs drains.

A titre illustratif, les transistors double-grille peuvent être des transistors double-grille planaire ou des transistors FinFET.

L'utilisation de transistors double-grille permet de réduire la surface par rapport à l'utilisation de deux transistors en parallèle.

De plus, un transistor double-grille est beaucoup moins sensible au problème de décrochement expliqué ci-dessus en relation avec la figure 1. Ainsi en référence à la figure 3, la tension de référence vctrl appliquée sur la seconde grille g2a" du premier transistor 3a" peut être choisie relativement élevée sans que la tension sur la première grille g1a" du premier transistor 3a" devienne inférieure à la tension de décrochement au-delà de laquelle le pseudo miroir de courant n'est plus fonctionnel. L'utilisation d'un transistor double-grille dans le circuit de polarisation de pied ou de tête assurant la régulation permet d'utiliser la tension de référence souhaitée sans qu'il soit nécessaire d'augmenter la taille des transistors utilisés dans ce circuit de polarisation pour éviter des problèmes de décrochement.

En outre, afin de diminuer encore les risques de décrochement on pourra utiliser des transistors double-grille asymétriques. De tels transistors possèdent une première grille plus influente que la seconde grille en termes de conduction du transistor. La tension de référence vctrl est alors appliquée sur la première grille du transistor asymétrique.

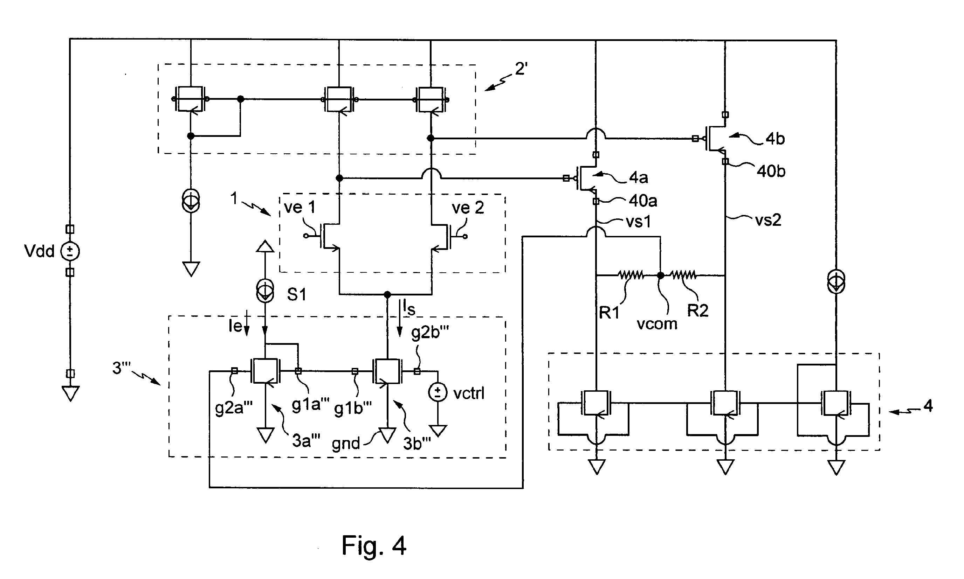

A la figure 4 est représenté un quatrième mode de réalisation d'un amplificateur comprenant une paire différentielle 1 avec contre-réaction du mode commun conforme à l'invention. La paire différentielle 1 est identique à celle du circuit représenté en figure 1.

Dans ce mode de réalisation, la polarisation de tête 2' est une polarisation identique à celle utilisée dans le troisième mode de réalisation, représenté à la figure 3.

Par ailleurs, le circuit amplificateur inclut un second étage d'amplification permettant d'augmenter le gain du circuit amplificateur. Ce second étage comprend des transistors 4a, 4b simple-grille de type MOS à canal P. Les sources des transistors 4a, 4b sont reliées à la tension d'alimentation Vdd. Les transistors 4a, 4b sont connectés respectivement aux drains des transistors 1 a, 1 b de la paire différentielle 1.

Une configuration en miroir de courant 4 polarise ces deux transistors 4a, 4b du second étage d'amplification.

Dans ce mode de réalisation, le premier signal de sortie vs1 est la tension au drain 40a du premier transistor 4a du second étage d'amplification et le second signal de sortie vs2 est la tension au drain 40b du second transistor 4b du second étage d'amplification.

L'extraction de la tension de mode commun de sortie vcom est réalisée par deux résistances R1, R2, de la même façon que dans les précédents modes de réalisation. On notera que cette fois, l'extraction est réalisée au niveau du second étage d'amplification.

La contre-réaction du mode commun est réalisée via une polarisation de pied 3''' de la paire différentielle 1. La polarisation de pied 3''' de la paire différentielle 1 est réalisée au moyen d'un premier élément électronique 3a''' et d'un second élément électronique 3b'''.

Ici, chacun des éléments électroniques 3a''', 3b''' connectés en configuration de « pseudo » miroir de courant comprend un transistor double-grille, de type MOS à canal N.

La première grille g1a''' du premier transistor ou élément 3a''' est connectée à la première grille g1b''' du second transistor ou élément 3b'''. En outre, la première grille g1a''' du premier transistor ou élément 3a''' est reliée au drain de ce transistor.

Contrairement aux modes de réalisation décrits ci-dessus, la seconde grille g2a''' du premier transistor ou élément 3a''' reçoit la tension de mode commun de sortie vcom (et non la tension de référence vctrl); et la seconde grille g2b''' du second transistor ou élément 3b''' reçoit la tension de référence vctrl (et non à la tension de mode commun de sortie vcom).

Du fait de l'ajout d'un nouvel étage d'amplification, le gain de l'amplificateur est négatif et il est ainsi nécessaire d'inverser la connexion des tensions de mode commun de sortie et de référence sur les éléments électroniques 3a''' et 3b''' de la polarisation de pied.

Bien entendu, dans ce mode de réalisation, il est possible de remplacer les transistors double-grille par des transistors à grille unique. Ainsi, la totalité des transistors du circuit peuvent être des transistors à une grille, des transistors à grilles multiples ou une partie de chaque type.

Malgré la différence évoquée ci-dessus, le fonctionnement de ce mode de réalisation, notamment, la polarisation de pied formée par les deux éléments électroniques connectés en « pseudo » miroir de courant, est similaire à celui représenté à la figure 1 et par conséquent il ne sera pas décrit en détail à nouveau.

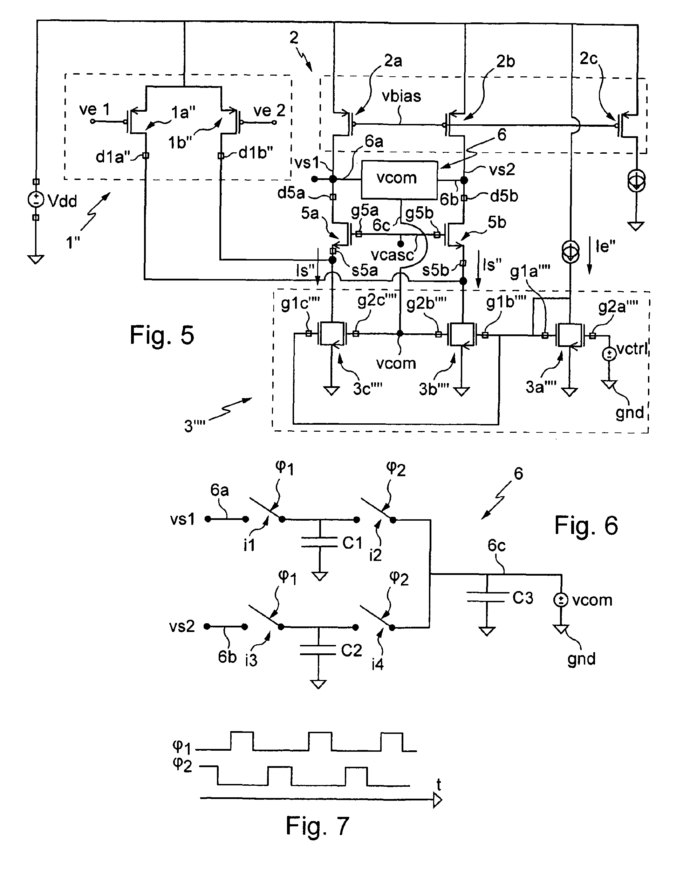

On va décrire en référence à la figure 5 un cinquième mode de réalisation d'un amplificateur comprenant une paire différentielle 1" avec contre-réaction du mode commun conforme à l'invention.

Ici, la paire différentielle 1" comprend deux transistors 1a", 1b" de type MOS à canal P. Les sources des transistors 1a", 1b" sont reliées à la tension d'alimentation Vdd. Les transistors 1a", 1b" reçoivent respectivement sur leurs grilles des tensions d'entrée ve1 et ve2.

L'amplificateur comprend en outre deux transistors 5a, 5b montés « en cascode » entre une polarisation de tête 2 et une polarisation de pied 3"". Les transistors 5a, 5b sont des transistors simple-grille de type MOS à canal N. Les grilles g5a, g5b des deux transistors 5a, 5b sont reliées l'une à l'autre. Cette grille commune g5a, g5b reçoit une tension de polarisation vcasc, qui peut être générée par un circuit extérieur au circuit amplificateur ou par un élément intérieur au circuit amplificateur. A titre illustratif, la tension de polarisation vcasc peut être générée au moyen d'un système en configuration de miroir de courant.

La polarisation de tête 2 est une polarisation classique identique à celle décrite pour le premier mode de réalisation, représenté à la figure 1.

Les drains d1a", d1b" des transistors 1a", 1b" de la paire différentielle 1", sont respectivement connectés aux sources s5a, s5b des transistors 5a, 5b.

Les transistors 5a, 5b connectés aux transistors 1a", 1b" de la paire différentielle 1" permettent d'obtenir une résistance d'entrée faible et en conséquence une tension sur chacun des drains d1 a", d1b" peu variable, contrairement aux paires différentielles classiques.

La polarisation de pied 3"" est réalisée au moyen de trois transistors double-grille 3a"", 3b"", 3c"", de type MOS à canal N. Les sources des transistors 3a"", 3b"", 3c"" sont reliées à la masse. Les premières grilles g1a"", g1b"", g1c"" des transistors 3a"", 3b"", 3c"" sont reliées les unes aux autres. La première grille g1a"" du premier transistor 3a"" est reliée au drain de ce dernier. La seconde grille g2a"" du premier transistor 3a"" reçoit la tension de référence vctrl. Les secondes grilles g2b"", g2c"" des deuxième et troisième transistors 3b"", 3c"" reçoivent la tension de mode commun de sortie vcom.

La première tension de sortie vs1 de l'amplificateur est la tension au drain d5a du transistor 5a et la seconde tension de sortie vs2 de l'amplificateur est la tension au drain d5b du transistor 5b.

Dans ce mode de réalisation, l'extraction de la tension de mode commun de sortie vcom est réalisée par un circuit d'extraction 6 (représenté à la figure 6) à deux entrées et une sortie. Une première entrée 6a reçoit la première tension de sortie vs1 et la seconde entrée 6b reçoit la seconde tension de sortie vs2. La sortie 6c délivre une tension égale à la tension de mode commun de sortie vcom.

La contre-réaction du mode commun est réalisée via la polarisation de pied 3" de la paire différentielle 1" selon un fonctionnement similaire à celui décrit pour le premier mode de réalisation, représenté à la figure 1.

Le circuit d'extraction 6 représenté en figure 6 comprend trois condensateurs C1, C2, C3. Il comprend également quatre interrupteurs i1, i2, i3, i4 actionnés par deux signaux binaires φ1, φ2 d'activation antagoniste ou signaux non recouvrants. Le signal φ1 actionne le premier interrupteur i1 et le troisième i3. Le signal φ2 actionne le deuxième interrupteur i2 et le quatrième i4.

Les premier et deuxième interrupteurs i1, i2 sont placés en série entre la première entrée 6a et la sortie 6c du circuit d'extraction. De même, les troisième et quatrième interrupteurs i3, i4 sont placés en série entre la seconde entrée 6b et la sortie 6c du circuit d'extraction. Le premier condensateur C1 est placé entre la masse et le noeud intermédiaire entre le premier interrupteurs i1 et le deuxième interrupteur i2. Le deuxième condensateur C2 est placé entre la masse et le noeud intermédiaire entre le troisième interrupteur i3 et le quatrième interrupteur i4. Le troisième condensateur C3 est placé entre la masse et la sortie 6c du circuit d'extraction.

Les signaux φ1, φ2 contrôlent le circuit d'extraction du mode commun de la façon décrite ci-après en relation avec le chronogramme représenté en figure 7.

Dans un état initial, les trois condensateurs C1, C2, C3 sont déchargés ou préchargés à la tension de référence souhaitée pour la tension de mode commun.

Lorsque le premier signal φ1 est activé (niveau du signal haut), il provoque la fermeture des premier et troisième interrupteurs i1, i3. Le signal φ2 est alors inactif (niveau du signal bas) et les deuxième et quatrième interrupteurs i2, i4 sont ouverts.

Ainsi, la tension aux bornes du premier condensateur C1 devient égale à la première tension de sortie vs1 et la tension aux bornes du second condensateur C2 devient égale à la seconde tension de sortie vs2.

Le premier signal φ1 est ensuite désactivé et pendant une courte période de temps les deux signaux φ1, φ2 sont inactivés (les deux signaux sont à l'état bas).

Le second signal φ2 est alors activé (niveau du signal haut) et le premier signal φ1 reste inactif (niveau du signal bas). Les premier et troisième interrupteurs i1, i3 restent ouverts et les second et quatrième interrupteurs i2, i4 se ferment.

Ainsi, il se produit une distribution des charges entre les premier, deuxième et troisième condensateurs C1, C2, C3.

Les premier et second signaux φ1, φ2 sont ensuite inactivés pendant une courte période de temps.

La séquence décrite ci-dessus est alors répétée en continu.

La tension de mode commun de sortie vcom est ainsi proportionnelle aux tensions de sortie vs1, vs2 de l'amplificateur.

Plus concrètement, la tension de mode commun de sortie vcom est calculée par l'équation suivante :

$$vcom = \frac{C1}{C1 + C2 + C3}\, vs1 + \frac{C2}{C1 + C2 + C3}\, vs2$$

Ainsi, lorsque les capacités des premier et second condensateurs et la deuxième capacité ont une valeur identique « C1 », la tension de mode commun de sortie vcom est la suivante :

$$vcom = \frac{C1}{2*C1 + C3}(vs1 + vs2) = \frac{2*C1}{2*C1 + C3} \cdot \frac{(Vs1 + Vs2)}{2}$$

En régime transitoire, la tension en sortie 6c du circuit d'extraction est en fait proportionnelle à la tension de mode commun de sortie. La tension en sortie 6c passe progressivement d'une valeur initiale, par exemple nulle, à une valeur égale à la tension de mode commun effective de l'amplificateur.

En régime établi, la tension en sortie 6c du circuit d'extraction suit les variations de la tension de mode commun de sortie effective de l'amplificateur.

Bien entendu, ce mode d'extraction de la tension de mode commun de sortie peut être utilisé dans tout type de circuit amplificateur selon la présente invention.

Selon une variante de réalisation du circuit amplificateur représenté en figure 5, les sources des transistors de la paire différentielle 1" pourraient être reliées à la tension d'alimentation par l'intermédiaire d'une polarisation de tête identique à la polarisation de tête 2 du circuit amplificateur représenté en figure 1.

Selon une autre variante du circuit de la figure 5, la polarisation de pied 3"" est remplacée par une polarisation classique, par exemple de type miroir de courant, avec un courant fixe prédéfini et on insère entre la paire différentielle 1" et l'alimentation Vdd une polarisation de tête 2' identique à celle utilisée dans le circuit de la figure 2. La rétro-action du mode commun de sortie est alors effectuée sur la polarisation de tête de la paire différentielle 1 ".

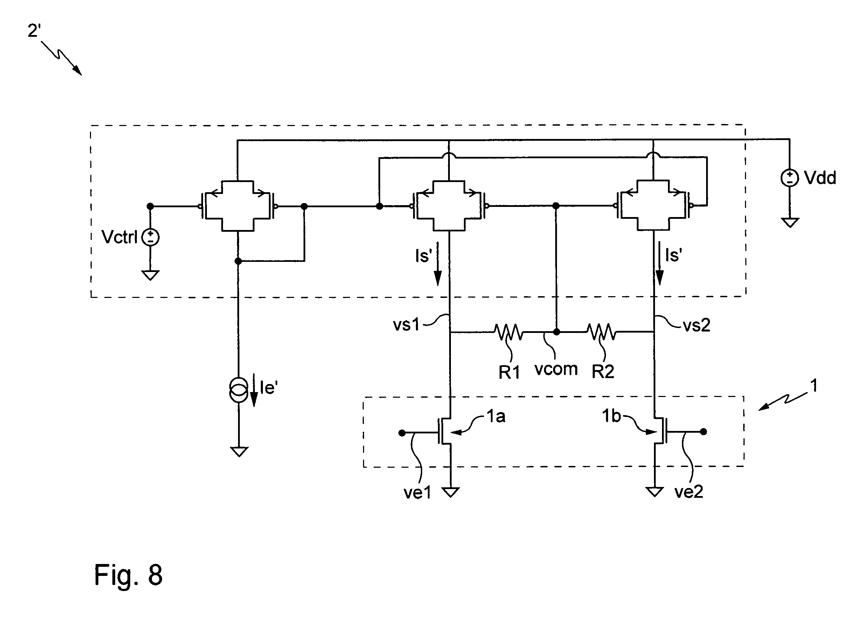

On va décrire en référence à la figure 8 un sixième mode de réalisation d'un amplificateur comprenant une paire différentielle 1 avec contre-réaction du mode commun conforme à l'invention. Ce mode de réalisation est particulièrement adapté lorsque la tension d'alimentation Vdd de l'amplificateur est faible, par exemple inférieure à 1 volt.

La paire différentielle 1 est identique à celle du circuit représenté en figure 1. Les sources des deux transistors 1 a, 1b sont ici directement reliées à la masse. Les transistors 1 a, 1b reçoivent respectivement les tensions d'entrée ve1, ve2. Les tensions présentes sur les drains des transistors 1a, 1b correspondent respectivement aux première vs1 et seconde vs2 tensions de sortie de l'amplificateur.

La paire différentielle 1 est reliée à une polarisation de tête 2' identique à celle du circuit représenté en figure 2. De même, la tension de mode de commun de sortie est extraite au moyen de deux résistances R1, R2 en série entre les drains des transistors 1 a, 1 b de la paire différentielle.

En fonctionnement, la régulation des variations de la tension de mode commun de sortie peut être expliquée comme suit. Les transistors de la paire différentielle 1 a, 1 b sont équivalents à des résistances. Ainsi, lorsque la tension de mode commun diminue à une valeur inférieure à la tension de référence vctrl, le courant Is' fourni par la polarisation à chaque transistor de la paire différentielle 1a, 1b augmente. Les tensions de sortie vs1, vs2 augmentent et par conséquent la tension de mode commun de sortie vcom remonte. Inversement, lorsque la tension de mode commun de sortie augmente à une valeur supérieure à la tension de référence vctrl, le courant Is' diminue. Les tensions de sortie vs1, vs2 diminuent et la tension de mode commun de sortie vcom diminue.

Grâce à l'invention, il est possible de réaliser une technique de contre-réaction du mode commun de sortie avec un impact en surface minime et sans augmentation de la consommation de courant.

La technique de contre-réaction du mode commun de sortie selon l'invention fonctionne pour tout type de circuit amplificateur comprenant un ou plusieurs étages d'amplification. De plus, la contre-réaction du mode commun de sortie peut-être réalisée sur le premier étage d'amplification ou sur un étage suivant. On notera cependant, qu'une rétro-action sur le premier étage d'amplification est préférable, car elle permet d'assurer une régulation « en cascode » sur tous les étages suivants.

On notera que selon le nombre d'étages d'amplification et selon l'étage où est appliquée la rétro-action, la tension de mode commun de sortie est appliquée dans une polarisation de pied ou de tête où a lieu la rétroaction soit sur l'élément électronique du pseudo-miroir de courant qui est monté partiellement en diode et qui reçoit le courant de référence (le) soit sur l'autre (ou les autres) élément(s) électronique du pseudo-miroir de courant. L'homme de l'art pourra aisément définir le lieu d'application de la tension de mode commun de sortie en fonction du type d'amplificateur utilisé.

La présente invention permet en outre de contrôler la valeur de la tension de mode commun de sortie de l'amplificateur et de diminuer la dépendance de cette dernière aux variations d'autres paramètres du circuit.

Bien entendu, de nombreuses modifications peuvent être apportées aux exemples de réalisation décrits précédemment sans sortir du cadre de l'invention.

En particulier, pour la conception d'un circuit électronique amplificateur conforme à l'invention, des transistors conventionnels à grille unique ou des transistors à grilles multiples, peuvent être utilisés indistinctement.

Bien entendu, une partie des transistors du circuit peuvent être des transistors à grille unique et une autre partie, des transistors à grilles multiples.

Ainsi, les éléments électroniques peuvent comprendre deux transistors connectés en parallèle ou un seul transistor double-grille. Le fonctionnement de deux transistors connectés en parallèle est équivalent à celui d'un transistor double-grille.

En outre, le circuit électronique amplificateur peut comprendre plusieurs étages d'amplification.

De plus, les circuits amplificateurs décrits ci-dessus peuvent être réalisés en logique complémentaire en remplaçant les transistors MOS à canal P par des transistors à canal N et inversement.

## Revendications

1. Circuit électronique amplificateur comprenant :

   - au moins un étage d'amplification, le premier étage d'amplification comprenant une paire différentielle (1 ; 1' ; 1") comprenant deux transistors d'entrée (1a, 1b ; 1a', 1b' ; 1a", 1b") commandés respectivement par deux signaux d'entrée (ve1, ve2);
   - des moyens de mesure (R1, R2 ; 6) de la tension de mode commun de sortie (vcom) de l'amplificateur à partir de deux signaux de sortie (vs1 ; vs2) ; et

   **caractérisé en ce qu'**il comprend:

   - au moins un premier (3a ; 2a' ; 3a" ; 3a''' ; 3a'''') et un deuxième éléments électronique (3b ; 2b' ; 3b" ; 3b''' ; 3b''''), chaque élément électronique (3a, 3b ; 2a', 2b' ; 3a", 3b" ; 3a''', 3b'''; 3a'''', 3b'''') comprenant une première grille (g1a, g1b ; g1a", g1b" ; g1a''', g1b''' ; g1a'''', g1b'''') et une seconde grille (g2a, g2b ; g2a", g2b", g2a''', g2b''', g2a'''', g2b''''), une source (s3a, s3b) et un drain (d3a, d3b), les premières grilles (g1a, g1b ; g1a", g1b" ; g1a''', g1b'''; g1a'''', g1b'''') des premier et deuxième éléments électroniques (3a, 3b ; 2a', 2b' ; 3a", 3b"; 3a''', 3b'''; 3a'''', 3b'''') étant connectées entre elles et au drain (d3a) du premier élément électronique (3a 2a' ; 3a" ; 3a''' ; 3a'''') et formant ainsi une configuration de miroir de courant, l'une des secondes grilles (g2a, g2b ; g2a", g2b"; g2a''', g2b'''; g2a'''', g2b'''') des premier et deuxième éléments électroniques (3a, 3b ; 2a', 2b', 3a", 3b"; 3a''', 3b'''; 3a'''', 3b'''') recevant la tension de mode commun de sortie mesurée (vcom), l'autre des secondes grilles recevant une tension de référence (vctrl), le premier élément électronique étant traversé par un courant de référence (le ; le' ; le"), le deuxième élément électronique (3b ; 2b' ; 3b" ; 3b''' ; 3b'''') étant adapté à polariser tout ou partie d'un desdits étages d'amplification.

2. Circuit électronique amplificateur conforme à la revendication 1, **caractérisé en ce que** ledit second élément électronique (3b ; 3b" ; 3b''') est relié à chacun des transistors (1a, 1b ; 1a', 1b' ; 1a", 1b") de la paire différentielle (1 ; 1' ; 1 ").

3. Circuit électronique conforme à la revendication 1, **caractérisé en ce qu'**il comprend un troisième élément électronique (2c' ; 3c''''), les première et seconde grilles du troisième élément électronique étant respectivement reliées aux première et seconde grilles du deuxième élément électronique (2b' ; 3b''''), les deuxième et troisième éléments électroniques étant chacun reliés à un des transistors (1a', 1b' ; 1a", 1b") de la paire différentielle (1' ; 1").

4. Circuit électronique amplificateur conforme à l'une des revendications 1 à 3, **caractérisé en ce que** la tension de mode commun de sortie (vcom) mesurée est appliquée à la seconde grille (g2b ; g2b' ; g2b" ; g2b'''') du second élément électronique (3b ; 2b' ; 3b" ; 3b''') et la tension de référence (vctrl) est appliquée à la seconde grille (g2a ; g2a' ; g2a" ; g2a'''') du premier élément électronique (3a ; 2a' ; 3a" ; 3a'''').

**5.** Circuit électronique amplificateur conforme à l'une des revendications 1 à 4, **caractérisé en ce que** la tension de mode commun de sortie (vcom) est extraite sur les bornes (10a, 10b) des transistors (1 a, 1 b ; 1 a', 1b' ; 1a", 1b") de la paire différentielle (1 ; 1' ; 1").

**6.** Circuit électronique amplificateur conforme à l'une des revendications 1 à 4, **caractérisé en ce** le nombre d'étages d'amplification de la différence des deux signaux d'entrée (ve1, ve2) appliqués aux transistors (1a, 1b ; 1a', 1b' ; 1a", 1b") de la paire différentielle (1 ; 1' ; 1 ") est impair, la tension de mode commun de sortie étant extraite au niveau du dernier étage d'amplification.

**7.** Circuit électronique amplificateur conforme à l'une des revendications 1 à 3, **caractérisé en ce que** la tension de mode commun de sortie (vcom) mesurée est appliqué à la seconde grille (g2a"') du premier élément électronique (3a"') et la tension de référence (vctrl) est appliquée à la seconde grille (g2b"') du second élément électronique (3b"').

**8.** Circuit électronique amplificateur conforme à la revendication 7, **caractérisé en ce que** la paire différentielle appartient à un premier étage d'amplification de la différence des deux signaux d'entrée (ve1, ve2) appliqués aux transistors (1a, 1b) de la paire différentielle (1) et **en ce que** le circuit électronique amplificateur comprend un second étage d'amplification de cette différence, la tension de mode commun de sortie (vcom) étant extraite sur les bornes (40a, 40b) des transistors (4a, 4b) du second étage d'amplification.

**9.** Circuit électronique amplificateur conforme à la revendication 7, **caractérisé en ce** le nombre d'étages d'amplification de la différence des deux signaux d'entrée (ve1, ve2) appliqués aux transistors (1a, 1b; 1a', 1b'; 1a", 1b") de la paire différentielle (1 ; 1' ; 1") est pair, la tension de mode commun de sortie (vcom) étant extraite au niveau du dernier étage d'amplification.

**10.** Circuit électronique amplificateur conforme à l'une des revendications 1 à 9, **caractérisé en ce qu'**un élément desdits éléments électroniques (3a, 3b ; 2a', 2b', 2c') comprend deux transistors simple-grille (M1a, M2a, M1b, M2b ; M1a', M2a', M1b', M2b') montés en parallèle.

**11.** Circuit électronique amplificateur conforme à l'une des revendications 1 à 9, **caractérisé en ce qu'**un élément desdits éléments électroniques (3a", 3b" ; 3a"', 3b"'; 3a"", 3b"", 3c"") comprend un transistor double-grille (3a", 3b"; 3a"', 3b"' ; 3a"", 3b"", 3c"") présentant deux grilles (g1a", g2a", g1b", g2b" ; g1a"', g2a"', g1b"', g2b"').

**12.** Circuit électronique amplificateur conforme à l'une des revendications 1 à 9, **caractérisé en ce qu'**un élément desdits éléments électroniques (3a, 3b ; 2a', 2b', 2c'; 3a", 3b" ; 3a"', 3b"' ; 3a"", 3b"", 3c"") comprend un transistor FinFET.

**13.** Circuit électronique amplificateur conforme à l'une des revendications 1 à 12, **caractérisé en ce que** les moyens de mesure (R1, R2) de la tension de mode commun (vcom) de sortie de la paire différentielle (1 ; 1' ; 1") comprennent deux résistances (R1, R2) placées en série entre deux sorties de l'amplificateur délivrant lesdits signaux de sortie (vs1, vs2).

**14.** Circuit électronique amplificateur conforme à l'une des revendications 1 à 12, **caractérisé en ce que** les moyens de mesure (6) de la tension de mode commun (vcom) de sortie comprennent des condensateurs (C1, C2, C3) et des interrupteurs (i1, i2, i3, i4).

Fig. 1

Fig. 2

Fig. 3

Fig. 4

Fig. 5

Fig. 6

Fig. 7

Fig. 8

<table>
<tr><td colspan="3">ᐤ</td></tr>
</table>

**Office européen**
**des brevets**

**RAPPORT DE RECHERCHE EUROPEENNE**

Numéro de la demande

EP 08 29 0259

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| A | KARANICOLAS A N ET AL: "A HIGH-FREQUENCY FULLY DIFFERENTIAL BICMOS OPERATIONAL AMPLIFIER" IEEE JOURNAL OF SOLID-STATE CIRCUITS, IEEE SERVICE CENTER, PISCATAWAY, NJ, US, vol. 26, no. 3, 1 mars 1991 (1991-03-01), pages 203-208, XP000222596 ISSN: 0018-9200 Page 204, "A. First- and Second-Stage design"; figure 2 Page 205, "B. Common-Mode Feedback Scheme"; figure 3 ----- | 1-14 | INV. H03F3/45 |
| A | US 6 664 912 B1 (ZANCHI ALFIO [US]) 16 décembre 2003 (2003-12-16) * colonne 6, ligne 14 - colonne 9, ligne 15; figure 3 * ----- | 1-14 | |
| A | GUANGMING YIN ET AL: "A 16-B 320-KHZ CMOS A/D CONVERTER USING TWO-STAGE THIRD-ORDER SIGMA DELTA NOISE SHAPING" IEEE JOURNAL OF SOLID-STATE CIRCUITS, IEEE SERVICE CENTER, PISCATAWAY, NJ, US, vol. 28, no. 6, 1 juin 1993 (1993-06-01), pages 640-646, XP000378422 ISSN: 0018-9200 Page 643, "F. Settling Behavior of the Integrator"; figure 3 ----- | 1-14 | DOMAINES TECHNIQUES RECHERCHES (IPC)<br><br>H03F |
| A | US 2002/149427 A1 (SCHRODINGER KARL [DE] ET AL SCHROEDINGER KARL [DE] ET AL) 17 octobre 2002 (2002-10-17) * alinéa [0066] - alinéa [0068]; figure 4 * ----- | 1-14 | |

Le présent rapport a été établi pour toutes les revendications

| Lieu de la recherche | Date d'achèvement de la recherche | Examinateur |
|---|---|---|
| Munich | 1 juillet 2008 | Lorenzo, Carlos |

CATEGORIE DES DOCUMENTS CITES

X : particulièrement pertinent à lui seul
Y : particulièrement pertinent en combinaison avec un
    autre document de la même catégorie
A : arrière-plan technologique
O : divulgation non-écrite
P : document intercalaire

T : théorie ou principe à la base de l'invention
E : document de brevet antérieur, mais publié à la
    date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**

EP 08 29 0259

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

01-07-2008

| Document brevet cité au rapport de recherche | | Date de publication | Membre(s) de la famille de brevet(s) | | Date de publication |
|---|---|---|---|---|---|
| US 6664912 | B1 | 16-12-2003 | AUCUN | | |
| US 2002149427 | A1 | 17-10-2002 | WO | 0215394 A1 | 21-02-2002 |
| | | | DE | 10042170 A1 | 07-03-2002 |
| | | | EP | 1310043 A1 | 14-05-2003 |

Pour tout renseignement concernant cette annexe : voir Journal Officiel de l'Office européen des brevets, No.12/82